# EUROPEAN PATENT SPECIFICATION

(11) **EP 4 075 666 B1**
(45) Date of publication and mention of the grant of the patent: **03.09.2025**
(21) Application number: 22168661.1
(22) Date of filing: 15.04.2022
(51) Int. Cl.: H02S 40/22, H10F 77/45

(54) **MULTI-LAYER COATING SLAB**
MEHRSCHICHTIGE PLATTE
DALLE MULTICOUCHE

(30) Priority: 15.04.2021 IT 202100009533
(43) Date of publication of application: 19.10.2022
(73) Proprietor: Sicis S.r.l., 20121 Milano (IT)
(72) Inventor: PLACUZZI, Maurizio Leo, I-20121 MILANO (IT)
(74) Representative: Mozzi, Matteo

(56) References cited:
- CN-A- 106 229 371
- CN-B- 108 231 939
- US-A1- 2010 139 765
- US-A1- 2011 114 174
- US-A1- 2012 138 125
- US-A1- 2015 194 555
- US-A1- 2018 342 638

## Description

### FIELD OF THE INVENTION

The present invention relates to the construction industry and in particular to a multi-layer coating slab.

### TECHNOLOGICAL BACKGROUND

As known, there are glass slabs that are usable in construction industry for coating exteriors in general or even for coating indoor environments.

In this regard, are known decorative multi-layer slabs which in addition to the support glass layers, typically an upper one facing the surrounding environment and the other one lower facing instead the surface or structure to which the coating slab is fixed, have a decorative film positioned between the two support layers.

A natural technological evolution of these coating slabs, considering that they are surfaces, even very large, exposed to the sun for several hours a day, was represented by providing these multi-layer coating slabs with photovoltaic cells either fixed to the outer surface exposed to the sun or inside the multi-layer structure, so as to convert the solar radiation incident on the coating slab into electricity.

However, the problem of dispersion of solar radiation is still apparent, making these coating panels or slabs unsatisfactory based on the increasingly demanding market needs, which, in addition to efficiency from a technological point of view, also require high quality even from an esthetic point of view.

Therefore, there is an increasingly felt need to have a multi-layer coating slab, which is reliably and efficiently capable of converting solar radiation into electricity, reducing the dispersion of solar radiation as much as possible, while simultaneously maintaining a remarkable esthetic effect.

US 2018/0342638 Al relates to a photovoltaic device capable of converting incident radiation, especially solar radiation, into electricity by means of solar (or photovoltaic) cells.

### SUMMARY OF THE INVENTION

It is the object of the present invention to devise and provide a multi-layer coating slab, which allows to solve at least partially the drawbacks claimed above with reference to the art, and which is capable of reliably and efficiently ensuring a conversion of solar radiation into electricity with high performance, while simultaneously maintaining a significant transparent, semi-transparent, and non-transparent esthetic effect.

Such an object is achieved by a multi-layer coating slab according to claim 1.

Preferred embodiments of such a coating slab are defined in the dependent claims.

### BRIEF DESCRIPTION OF THE DRAWINGS

Further features and advantages of the multi-layer coating slab according to the invention will become apparent from the following description of preferred embodiments, given by way of indicative, non-limiting examples, with reference to the accompanying drawings, in which:
- figure 1 shows an exploded perspective view of a multi-layer coating slab according to an embodiment of the invention;
- figure 2a shows a side section view of the slab in figure 1;
- figure 2b shows an enlarged view of a portion of figure 2a;
- figure 3 shows an exploded perspective view of a multi-layer coating slab according to a further embodiment of the invention;
- figure 4a shows a side section view of the slab in figure 3;
- figure 4b shows an enlarged view of a portion of figure 4a;
- figure 5 shows an exploded perspective view of a multi-layer coating slab according to a further embodiment of the invention;
- figure 6a shows a side section view of the slab in figure 5;
- figure 6b shows an enlarged view of a portion of figure 6a;
- figure 7 shows an exploded perspective view of a multi-layer coating slab according to a further embodiment of the invention;
- figure 8a shows a side section view of the slab in figure 7;
- figure 8b shows an enlarged view of a portion of figure 8a;
- figure 9 diagrammatically shows an example of technological operation of a multi-layer coating slab according to an embodiment of the present invention, and
- figure 10 shows, by means of a graph, the time variation in the process temperature for manufacturing a multi-layer coating slab according to the present invention.

It should be noted that, in the aforesaid figures, equivalent or similar elements are indicated by the same numeric and/or alphanumeric reference.

### DETAILED DESCRIPTION

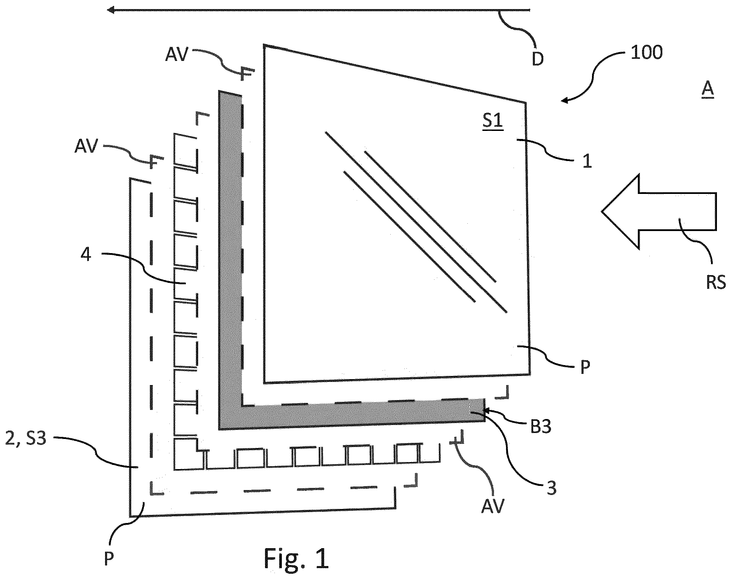

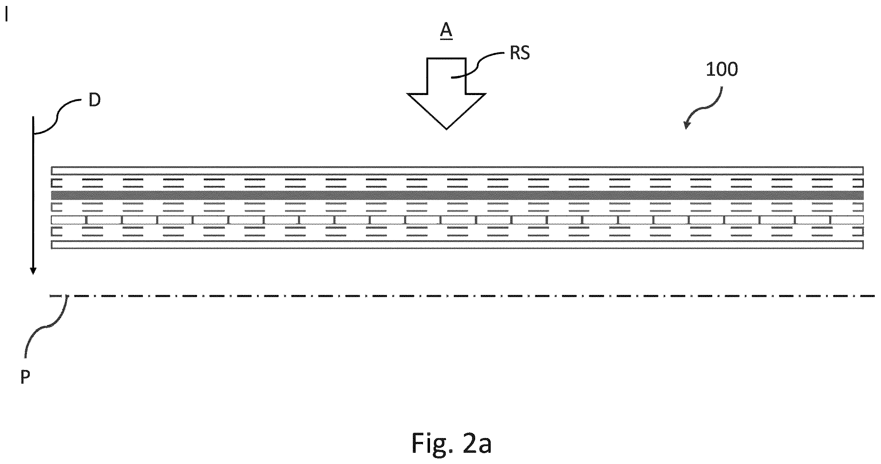

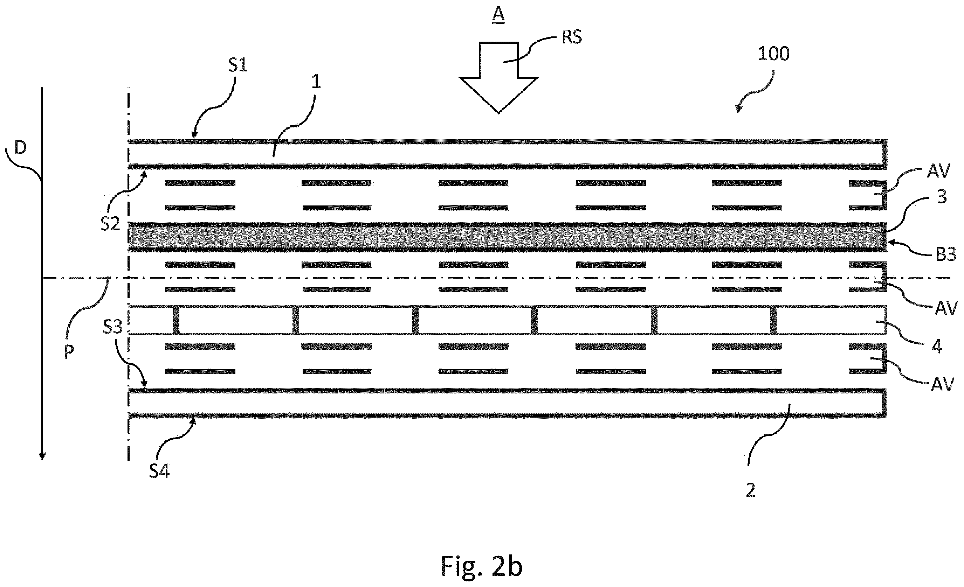

With reference to the aforesaid figures 1 and 2a-2d, a multi-layer coating slab (or sheet), hereafter even only multi-layer slab or simply slab, according to the invention as a whole and in further embodiments, is indicated by numerical reference 100.

In general, the slab 100 can be defined as a decorative transparent, semi-transparent, and non-transparent multi-layer coating slab.

Furthermore, the slab 100, as it will be also described below, in addition to ensuring a decorative (transparent, semi-transparent, and non-transparent) effect, is capable of performing technological functions.

The slab 100 has a main extension plane P.

In an embodiment of the present invention, said main extension plane P has a planar geometry.

In a further embodiment of the present invention, as an alternative to the previous one, said main extension plane P has a curved geometry.

Said curved geometry is characterized by the specific curvature, defined in each point thereof as a function of the radius of curvature.

The presence of optical distortions due to the curved geometry of the main extension plane P is a function of the thickness of the slab 100, defined along the direction perpendicular to said main extension plane P, and of the radius of curvature.

Optimizing the thickness and radius of curvature parameters, it is possible to obtain different optical distortion values for the slab 100.

In an embodiment, the main extension plane P has a curved geometry characterized by a constant radius of curvature.

According to the previous embodiment, the curved geometry of said main extension plane P is a function of the radius of curvature and angle of curvature parameters.

Preferably, the minimum radius of curvature is 200 mm.

Even more preferably, the minimum radius of curvature is 600 mm.

Preferably, the angle of curvature is between 0 and 180 degrees, even more preferably between 0 and 120 degrees.

Each layer of the slab 100 extends parallel to the main extension plane P.

For this reason, any one of the layers of the slab 100 is indicated in figures 1, 3, 5, and 7 as the main extension plane P of the slab 100.

The main extension plane P is symbolically indicated by a dotted line in figures 2a, 2b, 4a, 4b, 6a, 6b, 8a and 8b.

The slab 100 along a direction D (indicated in the figures by an arrow), substantially perpendicular to the main extension plane P, comprises a first transparent material layer 1 having a first surface S1 and an opposing second surface S2.

The first surface S1, when the slab 100 is in use, faces the surrounding environment A to be exposed to solar radiation RS (also symbolically represented by an arrow in the figures).

The first transparent material layer 1 has a thickness, for example, in the range from 3 to 10 mm.

The first transparent material layer 1 is, for example, glass or any other transparent polymer material, such as polymethylmethacrylate, polycarbonate, and so on.

Preferably, said first transparent material layer 1 is a solar glass, known per se.

The first transparent material layer 1 is suitable for performing a protective function since it is resistant to weathering, chemical products, and so on.

In an embodiment, the first transparent material layer 1 comprises a micro-prismatic surface.

Such a micro-prismatic surface comprises geometric micro-imperfections of variable shape, depth and direction on the surface of the first transparent material layer 1.

Such a micro-prismatic surface has the function of reducing the reflections and optimizing the transfer of the sun's rays inside the slab 100.

In a further embodiment, the first transparent material layer 1 comprises a nanometric anti-reflective coating.

Such a nanometric anti-reflective coating has the function of decreasing the natural surface reflection component of the glass.

Preferably, said micro-prismatic surface and said anti-reflective coating are made on the first surface S1 of the first transparent material layer 1.

The slab 100, along the direction D substantially perpendicular to the main extension plane P, further comprises a second transparent material layer 2 having a respective first surface S3 and an opposing second surface S4.

When the slab 100 is in use, the second surface S4 faces a support structure or surface (not shown in the figure) onto which the slab 100 is installable.

The second transparent material layer 2 has a thickness, for example, in the range from 3 to 10 mm.

The second transparent material layer 2 is, for example, glass or any other transparent polymer material, such as polymethylmethacrylate, polycarbonate, and so on.

The second transparent material layer 2 is suitable for performing a protective function since it is resistant to weathering, chemical products, and so on.

The slab 100, again along the direction D, substantially perpendicular to the main extension plane P, further comprises at least a first intermediate solar radiation concentrating layer 3, interposed between the first transparent material layer 1 and the second transparent layer 2 and delimited by a peripheral edge B3.

The at least a first intermediate layer 3 comprises a distribution of nanoparticles therein so as to deviate a set spectral component of the solar radiation RS from the surrounding environment A and incident on the first transparent material layer 100 towards the peripheral edge B3 of the at least a first intermediate solar radiation concentrating layer 3. Specifically, the at least a first intermediate layer 3 comprises a distribution of nanoparticles therein such as to absorb a set spectral component of the solar radiation RS from the surrounding environment A and incident on the first transparent material layer 100 and re-emit it isotropically at greater wave lengths.

Part of the solar radiation RS re-emitted by the nanoparticles is conveyed in a beam orthogonal to the source towards the peripheral edge B3 of the at least a first intermediate solar radiation concentrating layer 3.

The at least a first intermediate layer 3 has, for example, a thickness in the range from 4 to 12 mm.

The at least a first intermediate layer 3 is made of any polymer material, in which it is possible to distribute nanoparticles therein.

Examples of such a polymer material include polymethylmethacrylate, polycarbonate, pteg, and so on.

Nanoparticles mean nanocrystals or nanostructures adapted to deviate a set spectral component of the solar radiation RS from the surrounding environment A and incident on the first transparent material layer 100 towards the peripheral edge B3 of the at least a first intermediate layer 3.

Nanoparticles means nanocrystals or nanostructures adapted to absorb a set spectral component of the solar radiation RS from the surrounding environment A and incident on the first transparent material layer 100 and re-emit said solar radiation RS at greater wavelengths towards the peripheral edge B3 of the at least a first intermediate layer 3.

Preferably, said distribution of particles re-emits the solar radiation isotropically at greater wavelengths in the range between 800 and 1400 nm.

Said nanoparticles can have an organic or inorganic origin.

Examples of nanocrystals or nanostructures adapted to absorb a set spectral component of the solar radiation RS from the surrounding environment A and incident on the first transparent material layer 100 and re-emit it isotropically at greater wavelengths towards the peripheral edge B3 of the at least a first intermediate layer 3, are, for example, nanocrystals of perovskite doped with Mn²⁺ or nanocrystals of perovskite CsPbCl₃ with a convenient level of doping.

Returning to the slab 100 according to the present invention, again with reference to the figures, the slab 100, again along the direction D, substantially perpendicular to the main extension plane P, further comprises at least a second decorative intermediate layer 4 (transparent, semi-transparent and non-transparent) interposed between the at least a first intermediate layer 3 and the second transparent material layer 2.

The at least a second decorative intermediate layer 4 has a thickness, for example, in the range from 0.1 to 0.5 mm.

According to the present invention, said at least a second decorative intermediate layer 4 comprises a distribution of a decorative component adapted to determine, along a direction parallel to said main extension plane P, a gradient of opacity.

The degree of transparency of the slab 100 is inversely proportionate to the amount of decorative component placed in the at least a second decorative intermediate layer 4.

Advantageously, the distribution of said decorative component inside said at least one decorative intermediate layer is not uniform, so that there are portions with a greater density of decorative component, portions with a smaller density of decorative component and/or portions in which the decorative component is not present, corresponding to opaque portions, semi-transparent portions and completely transparent portions, respectively.

According to a preferred embodiment, said distribution of said decorative component determines, along a direction parallel to said main extension plane P, a gradient of opacity with increasing opacity going from the center of the slab 100 to the peripheral edge.

According to a preferred embodiment, said at least a second decorative intermediate layer 4 is completely opaque for a portion close to the peripheral edge of the slab 100.

The term "portion close to the peripheral edge of the slab" means a completely opaque portion of said at least a second decorative intermediate layer 4, which extends from said peripheral edge of the slab 100 towards the center of the slab 100 over a set distance, such as to preserve the transparent and decorative features in the central portion of the slab 100.

Preferably, the set distance from said peripheral edge of the slab 100 is equal to at least 2 mm so as not to affect the transparency and decoration.

Completely opaque means a zone in which the transmittance of the light is about0.

The transmittance of the light is defined as the capacity of a material to be crossed by part of the incident light.

According to this embodiment, the at least a second decorative intermediate layer 4 is completely opaque close to the peripheral edge of the slab 100 by virtue of the greater amount of decorative component present close to the peripheral edge of the decorative intermediate layer.

The at least a second decorative intermediate 4 layer is, for example, any transparent polymer material, such as polymethylmethacrylate, polycarbonate, pteg, and so on.

The decorative component present in the at least a second decorative intermediate layer 4 is, for example, a printed polymer decoration, a decorative metal or non-metal fabric (e.g., nets), and so on.

The decorative metal fabric comprises a metal component, preferably in the form of interwoven fibers, optionally coated.

Preferably, the decorative component present in the at least a second decorative intermediate layer 4 comprises pigments of different colors therein.

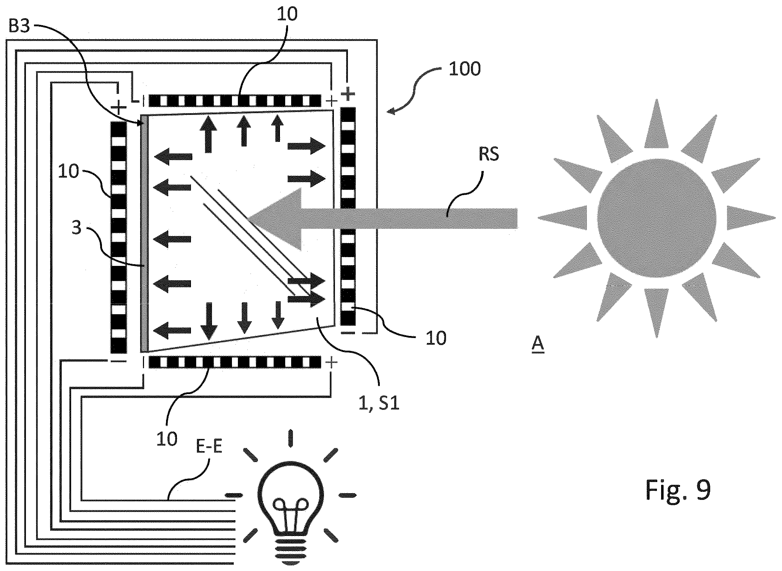

Returning to the slab 100 according to the present invention, with particular reference to figure 9, the slab 100 further comprises at least one photovoltaic element 10 fixed to the slab 100 so that at least one portion of the photovoltaic element 10 overlaps a portion of the peripheral edge B3 of the at least a first intermediate solar radiation concentrating layer 3 to convert the solar radiation RS re-emitted by the nanoparticles and conveyed in a beam orthogonal to the source towards the peripheral edge B3 into electricity E-E, e.g., an electric current or electric voltage.

The at least one photovoltaic element 10 is fixed to the slab 100 by gluing or in adherence through mechanical fixing.

According to a further embodiment, in combination with the previous one and shown in figure 9, the at least one photovoltaic element 10 comprises a strip of photovoltaic elements fixed to the slab so that the strip of photovoltaic elements overlaps the peripheral edge B3 of the at least a first intermediate solar radiation concentrating layer 3 to convert the solar radiation RS re-emitted by the nanoparticles and conveyed in a beam orthogonal to the source towards the peripheral edge B3 into electricity E-E.

Preferably, said at least one photovoltaic element 10 overlaps parallel and orthogonal to the peripheral edge B3 of the at least a first intermediate solar radiation concentrating layer 3.

In this embodiment, in which the photovoltaic element 10 completely overlaps the peripheral edge B3 of the at least a first intermediate solar radiation concentrating layer 3, a greater efficiency of the slab 100 is ensured since a greater amount of solar radiation RS is converted into electricity E-E.

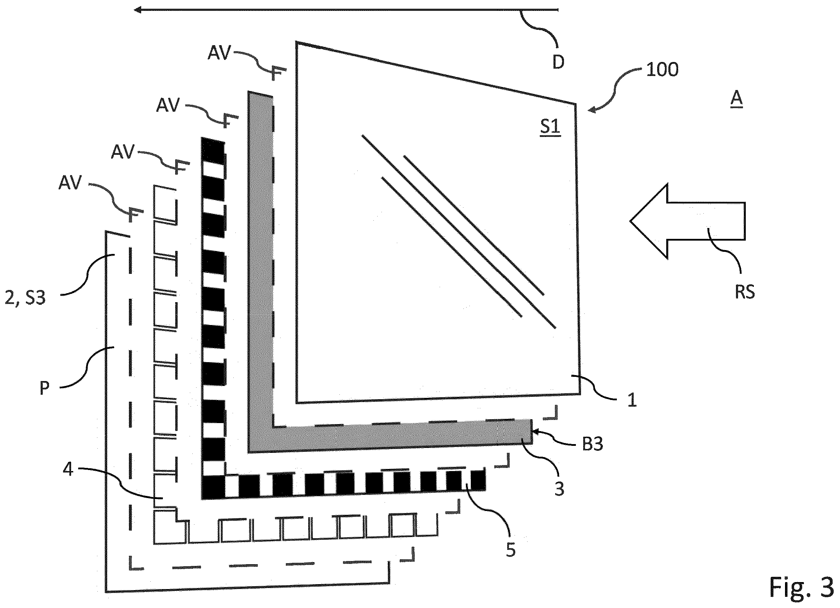

According to an embodiment, in combination with the previous one and shown in figures 3, 4a, 4b, 5, 6a, 6b, 7, 8a and 8b, the slab 100 further comprises an auxiliary solar radiation reflecting layer 5, interposed below said at least a first intermediate layer 3.

The auxiliary solar radiation reflecting layer 5 has an inner composition such as to reflect the set spectral component of the solar radiation RS, dispersed beyond the at least a first intermediate solar radiation concentrating layer 3, towards said at least a first intermediate solar radiation concentrating layer 3.

In other words, the auxiliary solar radiation reflecting layer 5 performs the function of an interfering mirror and advantageously allows reflecting again, towards the at least a first intermediate solar radiation concentrating layer 3, thus recovering, the solar radiation that, not having been conveyed in a beam orthogonal to the source by the at least a first intermediate solar radiation concentrating layer 3 towards the peripheral edge B3 of the at least a first intermediate solar radiation concentrating layer 3, was dispersed below the at least a first intermediate solar radiation concentrating layer 3, increasing the efficiency and reliability of the slab 100 in terms of reduction of the solar radiation dispersion and performance in terms of generation of electricity from solar radiation.

Preferably, the auxiliary solar radiation reflecting layer 5 has an inner composition such as to reflect the spectral component of the solar radiation RS related to the near field infrared.

The auxiliary solar radiation reflecting layer 5 has, for example, a thickness in the range from 0.1 to 0.5 mm. The auxiliary solar radiation reflecting layer 5 is a transparent material, such as glass or other transparent polymer material, such as polymethylmethacrylate, polycarbonate, pteg, and so on.

It should be noted that the mirror interfering effect at the set spectral component adapted to cause the operation of the nanoparticles distributed inside the at least a first intermediate solar radiation concentrating layer 3 can also be obtained by a coating of a layer made of a polymer or glass material.

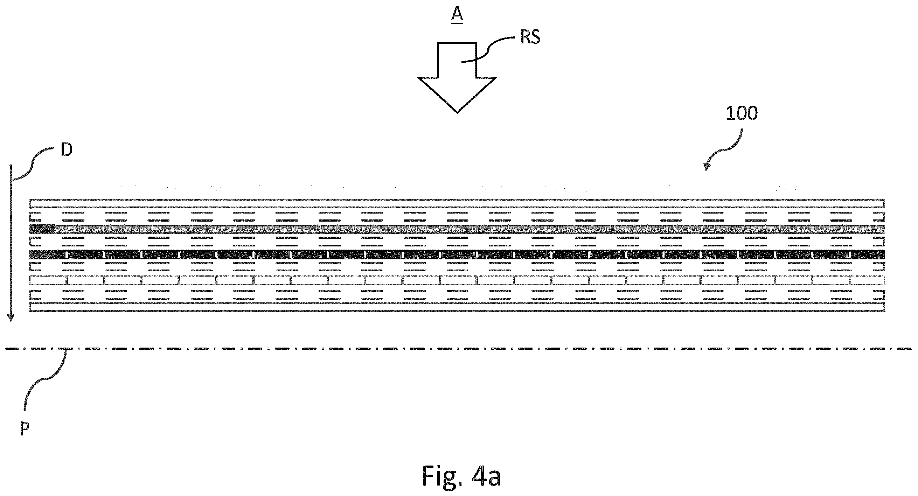

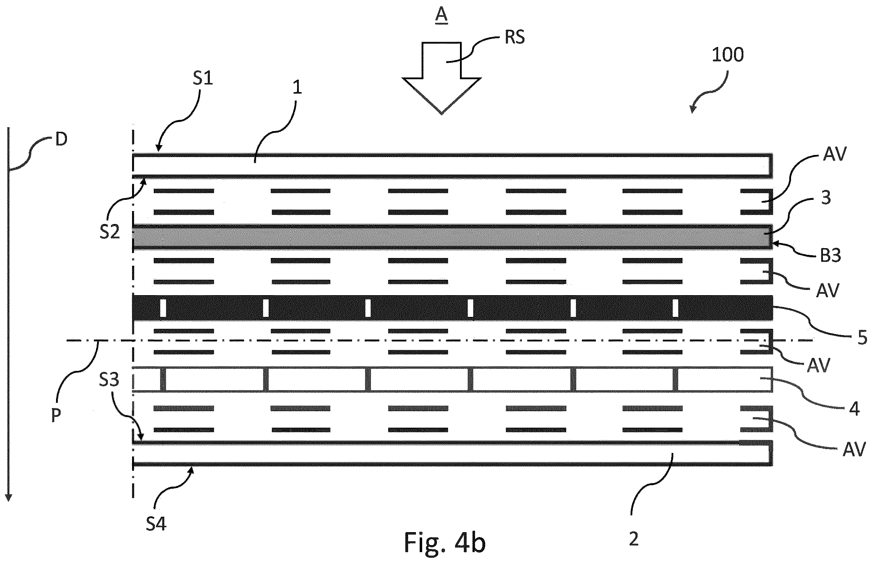

According to an embodiment, in combination with the previous one and shown in figures 3, 4a, 4b, the auxiliary solar radiation reflecting layer 5 is interposed between the at least a first intermediate solar radiation concentrating layer 3 and the at least a second decorative intermediate layer 4.

Advantageously, the solar radiation possibly dispersed below the at least a first intermediate solar radiation concentrating layer 3 and reflected by the auxiliary solar radiation reflecting layer is thus prevented from damaging the decoration made on the at least a second auxiliary decorative layer 4, keeping the overall esthetic appearance of the slab 100 unaltered for longer in time.

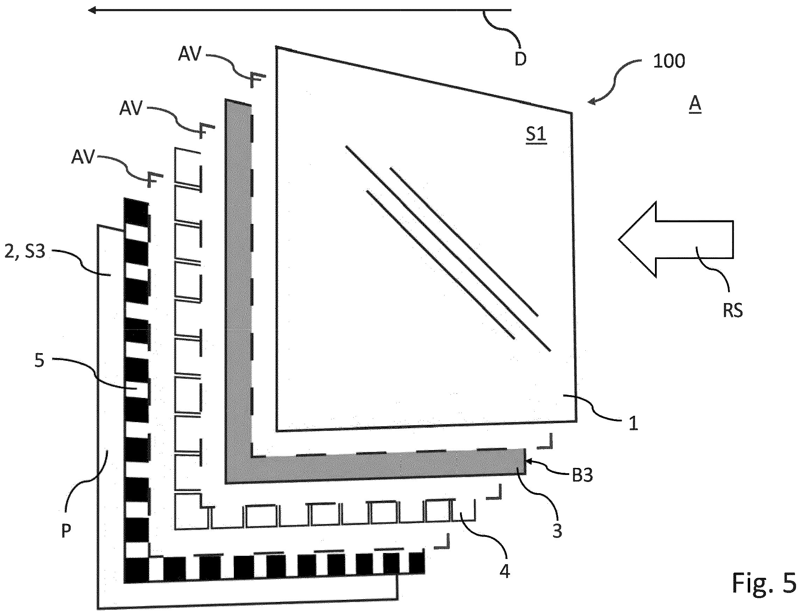

According to an embodiment, as an alternative to the previous one and shown in figures 5, 6a, 6b, 7, 8a and 8b, the auxiliary solar radiation reflecting layer 5 is arranged below the at least a second decorative intermediate layer 4.

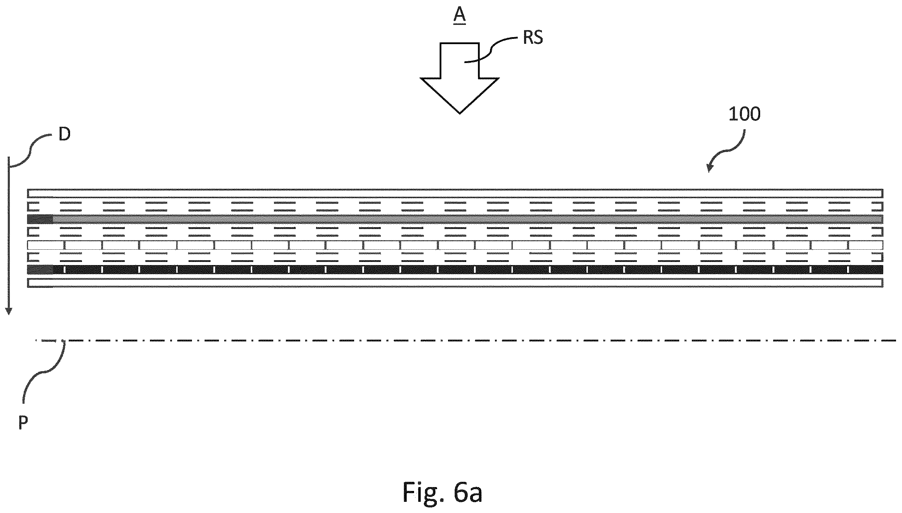

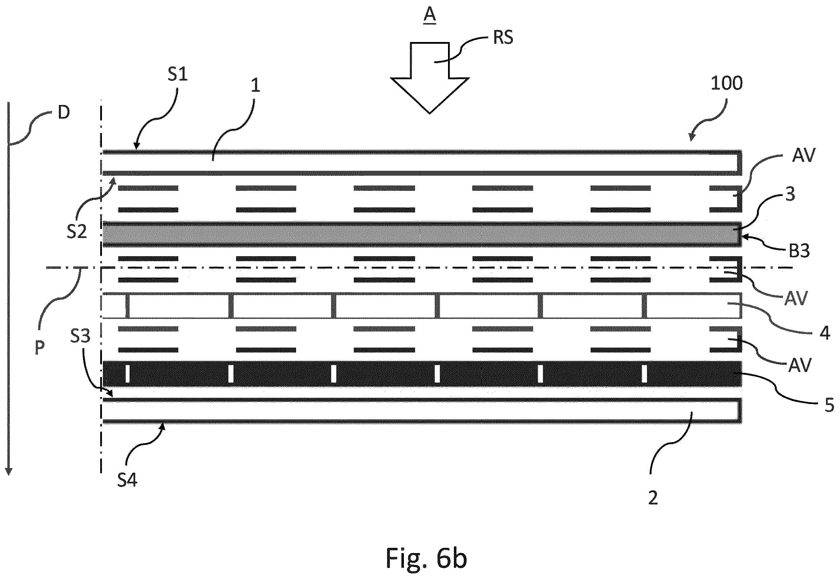

According to an embodiment, in combination with the previous one and shown in figures 5, 6a and 6b, the auxiliary solar radiation reflecting layer 5 is interposed between the at least a second decorative intermediate layer 4 and the second transparent material layer 2.

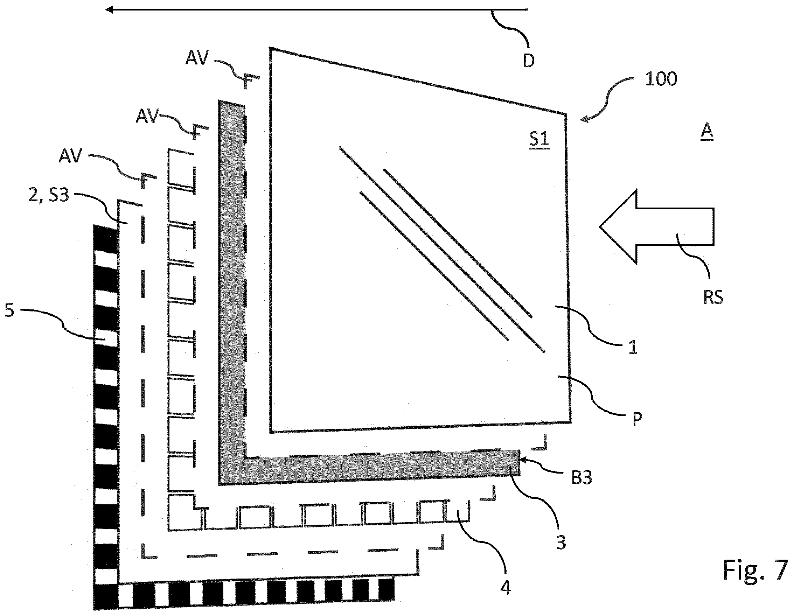

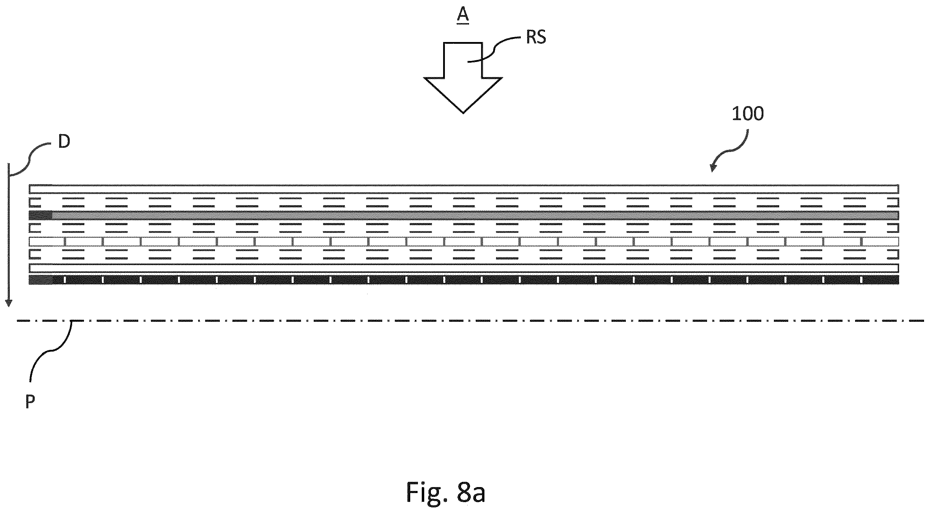

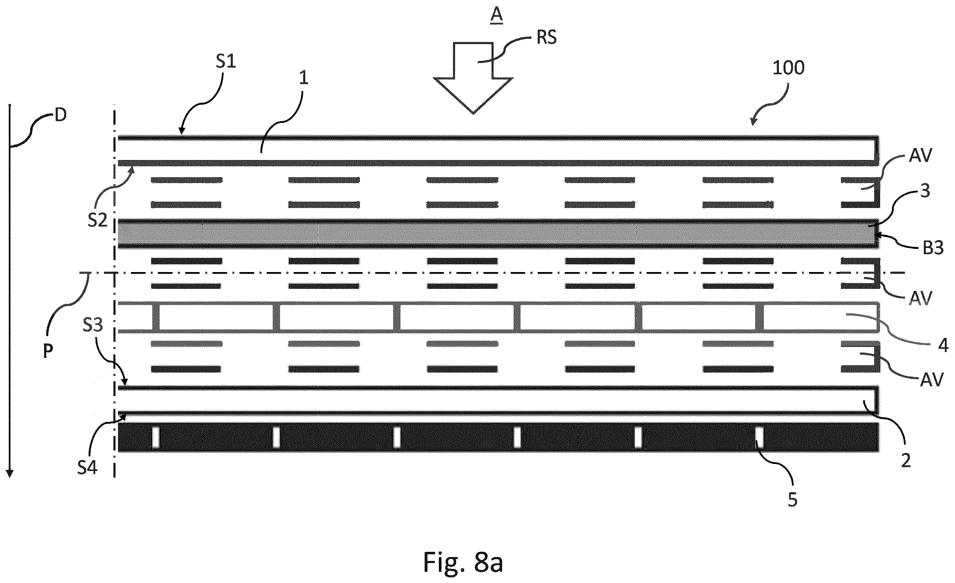

According to an embodiment, as an alternative to the previous one and shown in figures 7, 8a and 8b, the auxiliary solar radiation reflecting layer 5 is arranged below the second transparent material layer 2.

According to a further embodiment, as an alternative to the previous ones and not shown in the figures, the auxiliary solar radiation reflecting layer 5 coincides with the second transparent material layer 2.

According to an embodiment, in combination with any one of those described above and shown in any one of figures 1, 2a, 2b, 3, 4a, 4b, 5, 6a, 6b, 7, 8a, 8b, the slab 100 further comprises a plurality of adhesive material layers AV.

Each layer of the multi-layer slab 100 is fixed to a layer adjacent thereto by means of an adhesive material layer of said plurality of adhesive material layers AV, interposed between the layer and the layer adjacent thereto.

Each adhesive material layer has a thickness, for example, in the range from 0.3 to 1 mm.

Examples of adhesive material include ethyl vinyl acetate, polyvinyl butyral, polyolefins, adhesives, and transparent resins, such as acrylics, epoxies, ms polymers, silicones and so on.

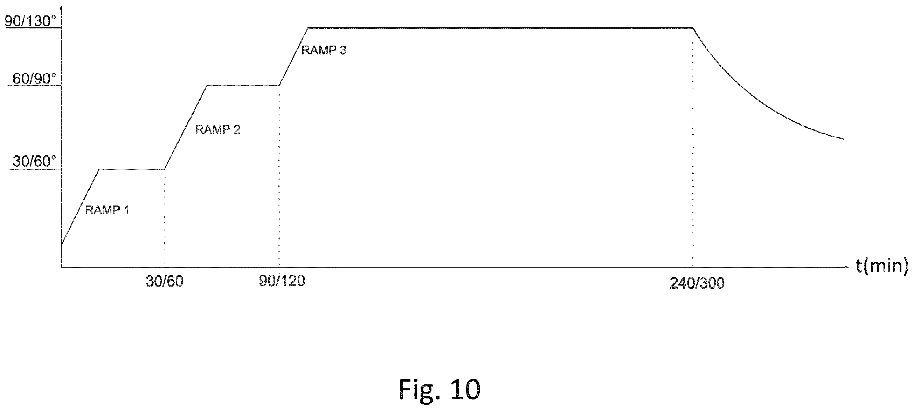

Referring now to figure 10, a process for manufacturing a multi-layer coating slab according to the present invention is now described.

The manufacturing process comprises positioning the layers forming the multi-layer slab, i.e., the first transparent material layer 1, the second transparent material layer 2, the at least a first intermediate solar radiation concentrating layer 3, the at least a second decorative intermediate layer 4, and possibly, if present, the auxiliary solar radiation reflecting layer 5 (in one of the positions provided according to the different embodiments previously described).

During the positioning, an adhesive material layer of the plurality of adhesive material layers, which can be provided inside the slab 100, is interposed between adjacent layers.

The slab 100 thus assembled undergoes cooking in a furnace with depression/pressure control according to a time trend of the operating temperature of the furnace, which comprises a first heating step, a second heating step, a third heating step, and a fourth cooling step, specifically studied to favor the polymerization of the material, preventing it from further de-laminating.

According to the example in figure 10:
- the first heating step has a duration from 30 to 60 minutes, in which there is an increase in the operating temperature of the furnace according to a ramp (RAMP 1) until it reaches and maintains a value between 30° and 60°;
- the second heating step has a duration from 90 to 120 minutes, in which there is a further increase in the operating temperature of the furnace according to a ramp (RAMP 2) until it reaches and maintains a value between 60° and 90°;
- the third heating step has a duration from 240 to 390 minutes, in which there is a further increase in the operating temperature of the furnace according to a ramp (RAMP 3) until it reaches and maintains a value between 90° and 130°;
- the fourth cooling step, which begins at the end of the third heating step, in which there is a gradual reduction in the operating temperature according to a decreasing curve until the slab 100 is taken out of the furnace.

Once cooled, the at least one photovoltaic element 10 is fixed to the slab 100.

With reference to figure 9, an example of technological operation of the slab 100 is now described according to an embodiment of the present invention.

The slab 100 is applied to an outer wall of a building (not shown in the figure) and the at least one photovoltaic element is electrically connected with an apparatus for distributing electricity of the building, symbolically shown in the figure by a lightbulb.

The solar radiation RS incises the slab 100, and after reaching the at least a first intermediate solar radiation concentrating layer 3, a set spectral component is deviated towards the peripheral edge B3 of the at least a first intermediate solar radiation concentrating layer 3, thus towards the at least one photovoltaic element 10.

The at least one photovoltaic element 10 converts the solar radiation received into electricity supplied to the electricity distribution apparatus.

It should be noted that the multi-layer coating slab according to the present invention can be applied to facades of buildings, parapets, balconies, verandas, and external coatings in general, skylights, coverings in general such as projecting roofs, partitions, and generally to all possible applications of glass, both outside and inside.

As can be seen, the object of the invention is fully achieved.

First, the decorative (transparent, semi-transparent and non-transparent) multi-layer coating slab, according to the present invention, maintains the decorative appearance, while ensuring an improved conversion of the solar radiation as compared to known technologies.

In fact, in one embodiment, the presence of the first layer of anti-reflecting solar glass increases the optical transmission and reduces the phenomena of the diffusion of incident radiation.

Furthermore, the presence of the at least a first intermediate solar radiation concentrating layer 3 inside the multi-layer slab and interposed between the first transparent material layer 1 and the second transparent layer 2, where the at least a first intermediate layer 3 comprises a distribution of nanoparticles therein, so as to absorb a set spectral component of the solar radiation RS from the surrounding environment A and incident on the first transparent material layer 100 and re-emit it at greater wavelengths towards the peripheral edge B3 of the at least a first intermediate solar radiation concentrating layer 3, advantageously allows reliably collecting the solar radiation towards the peripheral edge, which is converted into electricity by the at least one photovoltaic element 10 fixed to the slab 100 at the peripheral edge of the at least one intermediate solar radiation concentrating layer 3.

Advantageously, the provision of at least a second decorative intermediate layer 4, comprising a distribution of a decorative component adapted to determine a gradient of opacity along a direction parallel to said main extension plane P, allows the light radiation absorbed by the nanoparticles embedded in said at least a first intermediate solar radiation concentrating layer 3 and re-emitted towards the peripheral edge of the solar radiation concentrating layer to be forced to remain inside the peripheral edge of said solar concentrating layer, so as to increase the efficiency of said at least one photovoltaic element 10 fixed to the peripheral edge B3 of the at least a first intermediate concentrating layer 3.

Advantageously, said at least a second decorative intermediate layer 4 according to the invention comprising a non-uniform distribution of said decorative component forms a slab with different degrees of transparency and increased esthetic appearance as compared to traditional slabs.

Advantageously, the distribution of the decoration is completely opaque close to the edges of the at least a second decorative intermediate layer 4, for a better solar concentration efficiency on the surface of the photovoltaic devices, thus reducing the effect of diffusion through the surfaces of the layer.

Advantageously, no further glass processing, such as etching or glazing, is required in order to obtain the opaque effect.

Furthermore, in a further embodiment, the additional presence of the auxiliary solar radiation reflecting layer 5 (interfering mirror) advantageously allows reflecting, again towards the at least a first intermediate solar radiation concentrating layer 3, then recovering, any solar radiation that, not having been deviated by the at least a first intermediate solar radiation concentrating layer 3 towards the peripheral edge B3 of the at least a first intermediate solar radiation concentrating layer 3, was dispersed below the at least a first intermediate solar radiation concentrating layer 3.

The efficiency and reliability of the slab 100 are certainly increased in terms of reducing the dispersion of solar radiation and performance in terms of generating electricity from solar radiation.

Those skilled in the art can make changes and adaptations to the embodiments of the multi-layer coating slab described above or can replace elements with others which are functionally equivalent, in order to meet contingent needs without departing from the scope of the following claims. All the features described above as belonging to a possible embodiment can be implemented irrespective of the other embodiments described.

## Claims

1. A multi-layer coating slab (100) having a main extension plane (P), said slab (100), along a direction (D) substantially perpendicular to the main extension plane (P), comprising:
- a first transparent material layer (1) having a first surface (S1) and an opposing second surface (S2), the first surface (S1), when the slab (100) is in use, facing the surrounding environment (A) in order to be exposed to solar radiation (RS);
- a second transparent material layer (2) having a respective first surface (S3) and an opposing second surface (S4), when the slab (100) is in use, the second surface (S4) facing a support surface or structure onto which the slab (100) is installable;
- at least a first intermediate solar radiation concentrating layer (3), interposed between the first transparent material layer (1) and the second transparent material layer (2) and delimited by a peripheral edge (B3), said at least a first intermediate layer (3) comprising a distribution of nanoparticles therein so as to absorb a set spectral component of the solar radiation (RS) from the surrounding environment (A) and incident on the first transparent material layer (1) and re-emit it at greater wavelengths towards the peripheral edge (B3) of the at least a first intermediate solar radiation concentrating layer (3);
- at least a second intermediate layer (4) interposed between the at least a first intermediate layer (3) and the second transparent material layer (2),
- at least one photovoltaic element (10), said at least one photovoltaic element (10) comprising a strip of photovoltaic elements fixed to the slab (100) so that the strip of photovoltaic elements overlaps one portion of the peripheral edge (B3) of the at least a first intermediate solar radiation concentrating layer (3) to convert the solar radiation (RS) re-emitted towards the peripheral edge (B3) into electricity (E-E),
**characterized in that**
said at least a second intermediate layer (4) is a decorative layer and comprises a distribution of a decorative component adapted to determine, along a direction parallel to said main extension plane (P), a gradient of opacity.

2. A slab (100) according to claim 1, wherein the distribution of said decorative component determines, along a direction parallel to said main extension plane (P), a gradient of opacity with increasing opacity from the center of the slab (100) to the peripheral edge.

3. A slab (100) according to any one of the preceding claims, wherein said at least a second decorative intermediate layer (4) is completely opaque close to the peripheral edge of the slab.

4. A slab (100) according to any one of the preceding claims, wherein said first transparent material layer (1) comprises a micro-prismatic surface.

5. A slab (100) according to any one of the preceding claims, wherein the first transparent material layer (1) comprises a nanometric anti-reflective coating.

6. A slab (100) according to any one of the preceding claims, wherein said micro-prismatic surface and said nanometric anti-reflective coating are made on the first surface (S1) of the first transparent material layer (1).

7. A slab (100) according to any one of the preceding claims, further comprising an auxiliary solar radiation reflecting layer (5) interposed below said at least a first intermediate layer (3), said auxiliary layer (5) having an inner composition such as to reflect the set spectral component of the solar radiation (RS), dispersed beyond the at least a first intermediate solar radiation concentrating layer (3), towards said at least a first intermediate solar radiation concentrating layer (3).

8. A slab (100) according to claim 7, wherein the auxiliary solar radiation reflecting layer (5) is interposed between the at least a first intermediate solar radiation concentrating layer (3) and the at least a second decorative intermediate layer (4).

9. A slab (100) according to claim 7, wherein the auxiliary solar radiation reflecting layer (5) is arranged below the at least a second decorative intermediate layer (4).

10. A slab (100) according to claim 9, wherein the auxiliary solar radiation reflecting layer (5) is interposed between the at least a second decorative intermediate layer (4) and the second transparent material layer (2).

11. A slab (100) according to claim 9, wherein the auxiliary solar radiation reflecting layer (5) is arranged below the second transparent material layer (2).

12. A slab (100) according to claim 9, wherein the auxiliary solar radiation reflecting layer (5) coincides with the second glass layer (5).

13. A slab (100) according to any one of the preceding claims, comprising a plurality of adhesive material layers (AV), each layer of the multi-layer slab (100) being fixed to a layer adjacent thereto by means of an adhesive material layer of said plurality of adhesive material layers (AV) interposed between the layer and the adjacent layer.

## Patentansprüche

1. Mehrschichtige Platte (100) aufweisend eine Haupterstreckungsebene (P), wobei die Platte (100) entlang einer Richtung (D), die sich im Wesentlichen senkrecht zu der Haupterstreckungsebene (P) erstreckt, umfasst:
- eine erste transparente Materialschicht (1) aufweisend eine erste Oberfläche (S1) und eine gegenüberliegende zweite Oberfläche (S2), wobei die erste Oberfläche (S1), wenn die Platte (100) verwendet wird, der umliegenden Umgebung (A) zugewandt ist, um der Sonnenstrahlung (RS) ausgesetzt zu werden;
- eine zweite transparente Materialschicht (2) aufweisend eine jeweilige erste Oberfläche (S3) und eine gegenüberliegende zweite Oberfläche (S4), wobei die zweite Oberfläche (S4), wenn die Platte (100) verwendet wird, einer Trägerfläche oder -struktur zugewandt ist, auf der die Platte (100) installiert werden kann;
- mindestens eine erste Zwischenschicht zur Sonnenstrahlungskonzentration (3), die zwischen der ersten transparenten Materialschicht (1) und der zweiten transparenten Materialschicht (2) angeordnet ist und durch einen Umfangsrand (B3) begrenzt wird, wobei die mindestens eine erste Zwischenschicht (3) eine Verteilung von Nanopartikeln umfasst, um eine eingestellte spektrale Komponente der Sonnenstrahlung (RS) aus der umliegenden Umgebung (A) und einfallend auf die erste transparente Materialschicht (1) zu absorbieren und sie mit größeren Wellenlängen zu dem Umfangsrand (B3) der mindestens einen ersten Zwischenschicht zur Sonnenstrahlungskonzentration (3) wieder zu strahlen;
- mindestens eine zweite Zwischenschicht (4), die zwischen der mindestens einen ersten Zwischenschicht (3) und der zweiten transparenten Materialschicht (2) angeordnet ist,
mindestens ein photovoltaisches Element (10), wobei das mindestens eine photovoltaische Element (10) einen Streifen von photovoltaischen Elementen umfasst, der an der Platte (100) befestigt wird, sodass der Streifen von photovoltaischen Elementen einen Abschnitt des Umfangsrands (B3) der mindestens einen ersten Zwischenschicht zur Sonnenstrahlungskonzentration (3) überlappt, um die Sonnenstralung (RS), die zu dem Umfangsrand (B3) wieder gestrahlt wird, in Elektrizität (E-E) umzuwandeln,
**dadurch gekennzeichnet, dass**
die mindestens eine zweite Zwischenschicht (4) eine dekorative Schicht ist und
eine Verteilung einer dekorativen Komponente umfasst, die eingerichtet ist, entlang einer Richtung, die sich parallel zu der Haupterstreckungsebene (P) erstreckt, einen Opazitätsgradienten zu bestimmen.

2. Platte (100) nach Anspruch 1, wobei die Verteilung der dekorativen Komponente entlang einer Richtung, die sich parallel zu der Haupterstreckungsebene (P) erstreckt, einen Opazitätsgradienten mit zunehmender Opazität von dem Zentrum der Platte (100) zu dem Umfangsrand bestimmt.

3. Platte (100) nach einem der vorhergehenden Ansprüche, wobei die mindestens eine zweite dekorative Zwischenschicht (4) in der Nähe des Umfangsrands der Platte vollständig undurchsichtig ist.

4. Platte (100) nach einem der vorhergehenden Ansprüche, wobei die erste transparente Materialschicht (1) eine mikroprismatische Oberfläche umfasst.

5. Platte (100) nach einem der vorhergehenden Ansprüche, wobei die erste transparente Materialschicht (1) eine nanometrische Antireflexbeschichtung umfasst.

6. Platte (100) nach einem der vorhergehenden Ansprüche, wobei die mikroprismatische Oberfläche und die nanometrische Antireflexbeschichtung auf der ersten Oberfläche (S1) der ersten transparenten Materialschicht (1) ausgebildet sind.

7. Platte (100) nach einem der vorhergehenden Ansprüche, ferner umfassend eine Sonnenstrahlung-Reflexion-Hilfssschicht (5), die unterhalb der mindestens einen ersten Zwischenschicht (3) angeordnet ist, wobei die Hilfsschicht (5) eine innere Zusammensetzung aufweist, um die eingestellte spektrale Komponente der Sonnenstrahlung (RS), die über die mindestens eine erste Zwischenschicht zur Sonnenstrahlungskonzentration (3) gestreut wird, zu mindestens einer ersten Zwischenschicht zur Sonnenstrahlungskonzentration (3) zu reflektieren.

8. Platte (100) nach Anspruch 7, wobei die Sonnenstrahlung-Reflexion-Hilfsschicht (5) zwischen der mindestens einen ersten Zwischenschicht zur Sonnenstrahlungskonzentration (3) und der mindestens einen zweiten dekorativen Zwischenschicht (4) angeordnet ist.

9. Platte (100) nach Anspruch 7, wobei die Sonnenstrahlung-Reflexion-Hilfsschichtt (5) unterhalb der mindestens einen zweiten dekorativen Zwischenschicht (4) angeordnet ist.

10. Platte (100) nach Anspruch 9, wobei die Sonnenstrahlung-Reflexion-Hilfsschicht (5) zwischen der mindestens einen zweiten dekorativen Zwischenschicht (4) und der zweiten transparenten Materialschicht (2) angeordnet ist.

11. Platte (100) nach Anspruch 9, wobei die Sonnenstrahlung-Reflexion-Hilfsschicht (5) unterhalb der zweiten transparenten Materialschicht (2) angeordnet ist.

12. Platte (100) nach Anspruch 9, wobei die Sonnenstrahlung-Reflexion-Hilfsschicht (5) mit der zweiten Glasschicht (5) übereinstimmt.

13. Platte (100) nach einem der vorhergehenden Ansprüche, umfassend eine Vielzahl von Haftmaterialschichten (AV), wobei jede Schicht der Mehrschichtplatte (100) mittels einer Haftmaterialschicht aus der Vielzahl von Haftmaterialschichten (AV), die zwischen der Schicht und der angrenzenden Schicht angeordnet ist, an einer benachbarten Schicht befestigt wird.

## Revendications

1. Une dalle de revêtement multicouche (100) ayant un plan principal d'extension (P), ladite dalle (100), selon une direction (D) sensiblement perpendiculaire au plan principal d'extension (P), comprenant :
- une première couche de matériau transparent (1) ayant une première surface (S1) et une seconde surface opposée (S2), la première surface (S1), lorsque la dalle (100) est en service, étant orientée vers l'environnement ambiant (A) afin d'être exposée au rayonnement solaire (RS) ;
- une seconde couche de matériau transparent (2) ayant une première surface respective (S3) et une seconde surface opposée (S4), lorsque la dalle (100) est en service, la seconde surface (S4) étant orientée vers une surface ou une structure de support sur laquelle la dalle (100) est installable ;
- au moins une première couche intermédiaire de concentration du rayonnement solaire (3), interposée entre la première couche de matériau transparent (1) et la seconde couche de matériau transparent (2) et délimitée par un bord périphérique (B3), ladite au moins une première couche intermédiaire (3) comprenant une distribution de nanoparticules en son sein de manière à absorber une composante spectrale déterminée du rayonnement solaire (RS) provenant de l'environnement ambiant (A) et incident sur la première couche de matériau transparent (1) et à la réémettre à des longueurs d'onde plus grandes vers le bord périphérique (B3) de ladite au moins une première couche intermédiaire de concentration du rayonnement solaire (3) ;
- au moins une seconde couche intermédiaire (4) interposée entre ladite au moins une première couche intermédiaire (3) et la seconde couche de matériau transparent (2),
au moins un élément photovoltaïque (10), ledit au moins un élément photovoltaïque (10) comprenant une bande d'éléments photovoltaïques fixée à la dalle (100) de sorte que la bande d'éléments photovoltaïques chevauche une portion du bord périphérique (B3) de ladite au moins une première couche intermédiaire de concentration du rayonnement solaire (3) afin de convertir le rayonnement solaire (RS) réémis vers le bord périphérique (B3) en électricité (E-E),
**caractérisée en ce que**
ladite au moins une seconde couche intermédiaire (4) est une couche décorative et
comprend une distribution d'un composant décoratif adaptée à déterminer, selon une direction parallèle audit plan principal d'extension (P), un gradient d'opacité.

2. Une dalle (100) selon la revendication 1, dans laquelle la distribution dudit composant décoratif détermine, selon une direction parallèle audit plan principal d'extension (P), un gradient d'opacité avec une opacité croissante du centre de la dalle (100) vers le bord périphérique.

3. Une dalle (100) selon l'une quelconque des revendications précédentes, dans laquelle ladite au moins une seconde couche intermédiaire décorative (4) est complètement opaque à proximité du bord périphérique de la dalle.

4. Une dalle (100) selon l'une quelconque des revendications précédentes, dans laquelle ladite première couche de matériau transparent (1) comprend une surface micro-prismatique.

5. Une dalle (100) selon l'une quelconque des revendications précédentes, dans laquelle ladite première couche de matériau transparent (1) comprend un revêtement antireflet nanométrique.

6. Une dalle (100) selon l'une quelconque des revendications précédentes, dans laquelle ladite surface micro-prismatique et ledit revêtement antireflet nanométrique sont réalisés sur la première surface (S1) de la première couche de matériau transparent (1).

7. Une dalle (100) selon l'une quelconque des revendications précédentes, comprenant en outre une couche auxiliaire de réflexion du rayonnement solaire (5) interposée sous ladite au moins une première couche intermédiaire (3), ladite couche auxiliaire (5) ayant une composition interne telle qu'elle réfléchisse la composante spectrale déterminée du rayonnement solaire (RS), dispersée au-delà de ladite au moins une première couche intermédiaire de concentration du rayonnement solaire (3), vers ladite au moins une première couche intermédiaire de concentration du rayonnement solaire (3).

8. Une dalle (100) selon la revendication 7, dans laquelle ladite couche auxiliaire de réflexion du rayonnement solaire (5) est interposée entre ladite au moins une première couche intermédiaire de concentration du rayonnement solaire (3) et ladite au moins une seconde couche intermédiaire décorative (4).

9. Une dalle (100) selon la revendication 7, dans laquelle ladite couche auxiliaire de réflexion du rayonnement solaire (5) est disposée sous ladite au moins une seconde couche intermédiaire décorative (4).

10. Une dalle (100) selon la revendication 9, dans laquelle ladite couche auxiliaire de réflexion du rayonnement solaire (5) est interposée entre ladite au moins une seconde couche intermédiaire décorative (4) et la seconde couche de matériau transparent (2).

11. Une dalle (100) selon la revendication 9, dans laquelle ladite couche auxiliaire de réflexion du rayonnement solaire (5) est disposée sous la seconde couche de matériau transparent (2).

12. Une dalle (100) selon la revendication 9, dans laquelle ladite couche auxiliaire de réflexion du rayonnement solaire (5) coïncide avec la seconde couche de verre (5).

13. Une dalle (100) selon l'une quelconque des revendications précédentes, comprenant une pluralité de couches de matériau adhésif (AV), chaque couche de la dalle multicouche (100) étant fixée à une couche adjacente au moyen d'une couche de matériau adhésif de ladite pluralité de couches de matériau adhésif (AV) interposée entre ladite couche et la couche adjacente.
